Europäisches Patentamt

European Patent Office

Office européen des brevets

(11) Veröffentlichungsnummer: **0 538 614 A2**

## (12) EUROPÄISCHE PATENTANMELDUNG

(21) Anmeldenummer: **92115453.0**

(51) Int. Cl.⁵: **H03K 17/08**

(22) Anmeldetag: **10.09.92**

(30) Priorität: **25.10.91 DE 4135259**

(43) Veröffentlichungstag der Anmeldung:
**28.04.93 Patentblatt 93/17**

(84) Benannte Vertragsstaaten:
**CH FR GB IT LI NL SE**

(71) Anmelder: **SEMIKRON ELEKTRONIK GMBH
Sigmundstrasse 200 Postfach 82 02 51
W-8500 Nürnberg 82(DE)**

(72) Erfinder: **Lutz, Josef
Knauer Strasse 11
W-8500 Nürnberg 70(DE)**
Erfinder: **Tursky, Werner, Dr.
Georg-Kraft-Strasse 7
W-8540 Schwabach(DE)**

(54) **Freilaufdiodeneinrichtung.**

㊗ Es wird eine Freilaufdiodeneinrichtung (10) für einen Kommutierungszweig beschrieben, die eine erste Diode (12) mit einem weichen Recovery-Verhalten und eine dazu parallelgeschaltete zweite Diode (14) mit einem snappigen Schaltverhalten aufweist.

FIG.1

EP 0 538 614 A2

Die Erfindung betrifft eine Freilaufdiodeneinrichtung für einen ein schaltbares Bauelement aufweisenden Kommutierungszweig.

In Schaltkreisen mit induktiver Last ist eine sog. Freilaufdiode angeordnet, wie z.B. in der älteren Patentanmeldung P 41 05 155.6 der Anmelderin beschrieben ist. Mit der Qualität der schaltbaren bzw. schaltenden Bauelemente wachsen auch die Anforderungen an die zugehörigen Freilaufdioden. Neben einer Sperrspannungsbelastbarkeit von z.B. größer als 1200 V, einem niedrigen Durchlaßspannungsabfall und einem geringen Rückstrom wird ein weiches Recovery-Verhalten, d.h. ein weiches Rückstromverhalten gefordert, bei dem es sich -wie in der DE 38 23 795 A1 der Anmelderin beschrieben- um eine dem dynamischen Verhalten der Diode zugeordnete Eigenschaft handelt, die das Ausräumen eines Plasmas von Ladungsträgern aus dem Halbleiterkörper beim Umschalten von der Durchlaßphase in die Sperrphase betrifft. Bei einem weichen Recovery-Verhalten klingt der Rückstrom im wesentlichen sanft ab. Da die induzierte Überspannung diesem Abklingverhalten entspricht, entsteht bei einer weich schaltenden Diode nur eine geringe Spannung, während bei einer Diode mit einem harten ("snappigen") Schaltverhalten hohe Spannungen induziert werden können. Kenngröße für das genannte Recovery-Verhalten ist der sog. Weichheitsfaktor, wie er in der oben genannten DE 38 23 795 A1 definiert ist.

Bei bekannten Bauformen von schnellen Leistungsdioden wird das Recovery-Verhalten bspw. durch Dotierung des Emitters, durch spezielle Emitter-Strukturen oder durch Protonenbestrahlung beeinflußt. Dabei zeigt sich jedoch, daß diese Maßnahmen zur Verbesserung des weichen Recovery-Verhaltens auf Kosten des Durchlaßspannungsabfalls gehen. Das bedingt hohe Durchlaß- und hohe Schaltverluste. Insbes. die Schaltverluste begrenzen den Einsatz der bekannten Freilaufdioden mit weichem Recovery-Verhalten.

Deshalb liegt der Erfindung die Aufgabe zugrunde, eine Freilaufdiodeneinrichtung der eingangs genannten Art zu schaffen, mit welcher bei der Kommutierung in einem Kommutierungszweig die Schaltverluste reduziert sind.

Diese Aufgabe wird erfindungsgemäß dadurch gelöst, daß die Freilaufdiodeneinrichtung eine erste Diode mit einem weichen Recovery-Verhalten und eine dazu parallel geschaltete zweite Diode mit einem snappigen Schaltverhalten aufweist, wobei die erste Diode auf weiches Schaltverhalten optimiert ist und nur einen relativ geringen Anteil des Vorwärtsstromes trägt, und die zweite Diode auf eine niedrige Durchlaßspannung und schnelles Schalten optimiert ist und einen im Vergleich zum Anteil der ersten Diode großen Anteil des Vorwärtsstromes trägt. Erfindungsgemäß ergibt sich eine Kombination des Vorteils eines niedrigen Durchlaßspannungsabfalls mit dem Vorteil eines weichen Recovery-Verhaltens durch die Parallelschaltung der beiden Dioden bei gleichzeitiger Reduzierung der Schaltverluste. Zu diesem Zweck werden zwei gänzlich verschiedene Typen von schnellen Dioden parallelgeschaltet. Hierbei ist -wie beschrieben worden ist- die erste, d.h. die ein weiches Recovery-Verhalten aufweisende Diode auf das Schaltverhalten optimiert; sie trägt nur einen geringen Teil des Vorwärtsstroms. Demgegenüber ist die zweite Diode auf niedrige Durchlaßspannung und schnelles Schalten optimiert. Sie trägt den größten Teil des Vorwärtsstromes. Durch die erfindungsgemäße parallelschaltung der beiden gänzlich verschiedenen Typen von schnellen Dioden sind nicht nur die Schaltverluste aufgeteilt, sondern es ergeben sich insgesamt wesentlich niedrigere Schaltverluste als bei den bekannten Kommutierungszweigen.

Bevorzugte Weiterbildungen der erfindungsgemäßen Freilaufdiodeneinrichtung sind in den Unteransprüchen gekennzeichnet.

Bei der erfindungsgemäßen Freilaufdiodeneinrichtung kann die erste Diode eine Diode sein, die eine breite $n^-$-Zone besitzt und in der das weiche Schaltverhalten durch eine niedrige Dotierung des $p^+$-Emitters erreicht wird. Sie kann auch eine Diode sein, bei der durch Protonenbestrahlung ein weiches Recovery-Verhalten eingestellt ist. Die zweite Diode kann eine schmale $n^-$-Zone aufweisen, wobei die Dotierung der $p^+$-Zone in Hinblick auf minimale Durchlaßspannung gewählt ist, die aber gleichzeitig ein "snappiges" Schaltverhalten aufweist. Selbstverständlich sind auch andere Diodenkombinationen möglich.

Das Verhältnis des Anteiles des Vorwärtsstromes der ersten Diode zum Anteil des Vorwärtsstromes der zweiten Diode kann größenordnungsmäßig 1:2 betragen oder kleiner als 1:2 sein.

Weitere Einzelheiten, Merkmale und Vorteile ergeben sich aus der nachfolgenden Beschreibung einer Meßschaltung zur Prüfung der erfindungsgemäßen Freilaufdiodeneinrichtung. Es zeigen:

Fig. 1    die Schaltungsanordnung der Meßschaltung zur Prüfung der Freilaufdiodeneinrichtung,
Fig. 2    das Schaltverhalten der ersten Diode der Freilaufdiodeneinrichtung,
Fig. 3    das Schaltverhalten der zweiten Diode der Freilaufdiodeneinrichtung,
Fig. 4    das Schaltverhalten der parallelschaltung der ersten und der zweiten Diode,
Fig. 5    die Stromaufteilung der beiden parallelgeschalteten Dioden der Freilaufdiodeneinrichtung in einem größeren Strommaßstab, und
Fig. 6    den zeitlichen Verlauf des Stromes in jeder der beiden parallel geschalteten Freilaufdioden zum Zeitpunkt der Kommutierung.

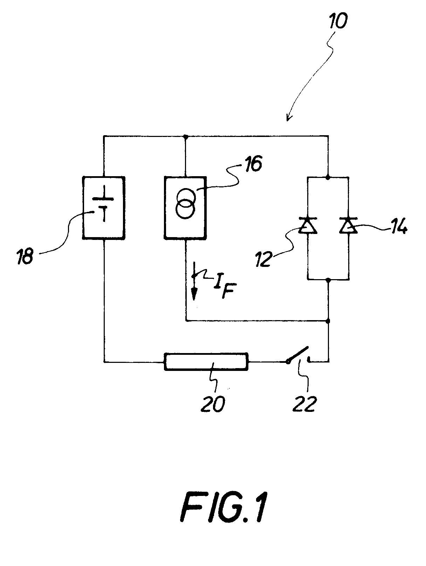

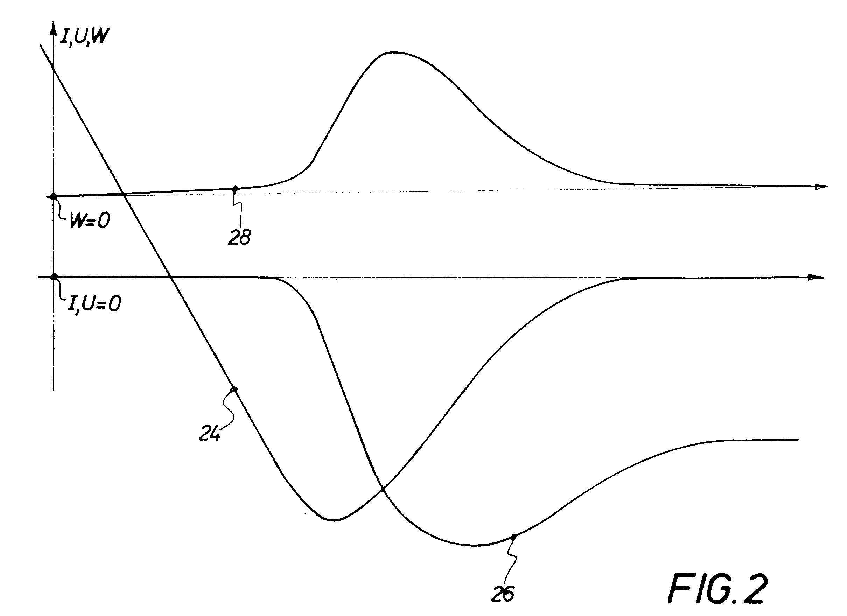

Fig. 1 zeigt die Freilaufdiodeneinrichtung 10 mit einer ersten Diode 12 und mit einer zweiten Diode 14, die zueinander parallelgeschaltet sind. Mit der Freilaufdiodeneinrichtung 10 ist eine Konstantstromquelle 16 sowie eine Konstantspannungsquelle 18 verbunden. Zwischen Konstantspannungsquelle 18 und Freilaufdiodeneinrichtung 10 ist eine induktive bzw. gemischt Ohmsch-induktive Last 20 und ein Schalter 22 geschaltet. Bei der ersten Diode 12 handelt es sich um eine Diode mit weichem Recovery-Verhalten, wie es in Fig. 2 gezeichnet ist, wobei in dieser Figur die Linie 24 den zeitlichen Verlauf des Stromes I, die Linie 26 den zeitlichen Verlauf der Spannung U und die Linie 28 die Schaltverluste W in Abhängigkeit von der Zeit darstellt.

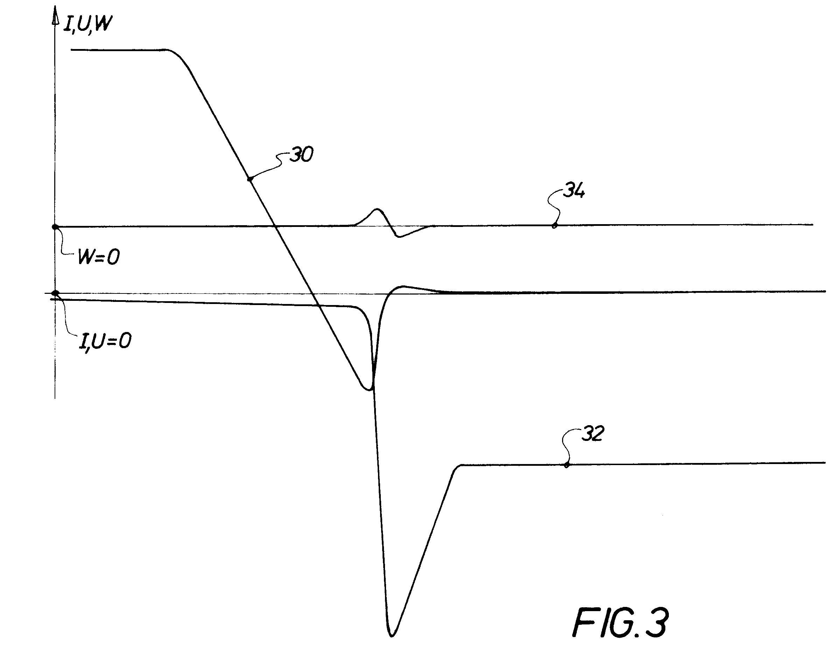

Die zur Diode 12 parallelgeschaltete zweite Diode 14 der Freilaufdiodeneinrichtung 10 ist die auf eine niedrige Durchlaßspannung und schnelles Schalten optimierte Diode, deren Schaltverhalten in Fig. 3 dargestellt ist, in welcher die Linie 30 die zeitliche Änderung des Stromes I, die Linie 32 die zeitliche Änderung der Spannung U und die Linie 34 die Verlustleistung W in Abhängigkeit von der Zeit darstellt. In den Figuren 2 und 3 weisen die Zeit-Abszisse und die Ordinate die gleichen Maßstäbe auf, woraus ohne weiteres das "snappige" Schaltverhalten der zweiten Diode 14 (sh. Fig. 3) ersichtlich wird.

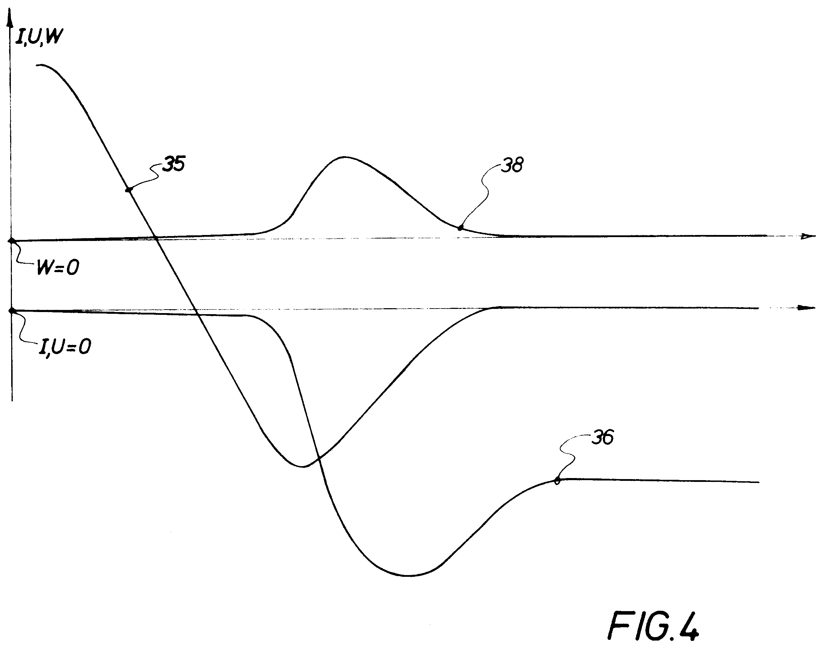

In Fig. 4 zeigt die Linie 35 die Änderung des Stromes I der Freilaufdiodeneinrichtung 10 mit der Zeit, die Linie 36 die zeitliche Änderung der Spannung U der Freilaufdiodeneinrichtung 10 und die Linie 38 die zeitliche Änderung der Verlustleistung W der Freilaufdiodeneinrichtung 10 bestehend aus den beiden parallelgeschalteten Dioden 12 und 14. Aus dieser Figur ist ersichtlich, daß die Freilaufdiodeneinrichtung 10 wiederum ein weiches Recovery-Verhalten besitzt, wobei jedoch im Vergleich zum Recovery-Verhalten der ersten Diode 12 -wie es aus Fig. 2 ersichtlich ist- eine wesentlich geringere Sperrverzögerungsladung und somit eine niedrigere Verlustleistung gegeben ist.

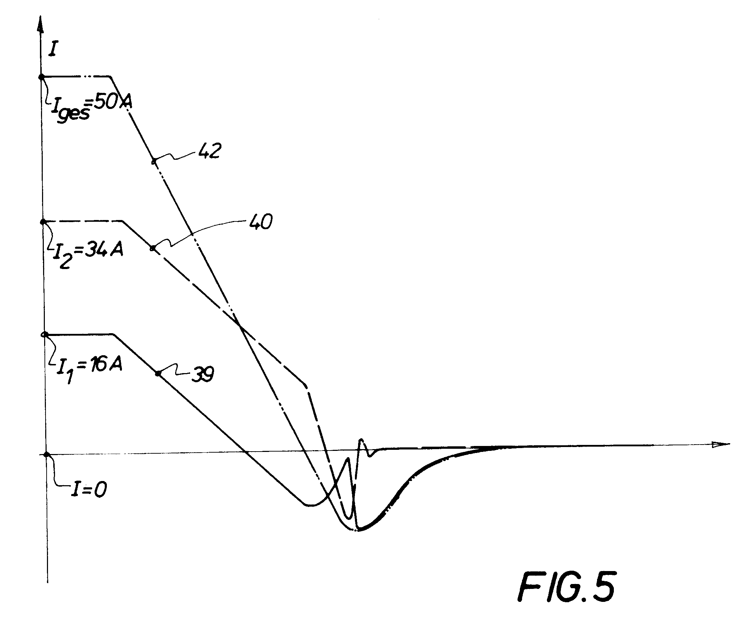

Die Fig. 5 zeigt die Aufteilung der elektrischen Ströme auf die beiden parallelgeschalteten Dioden 12 und 14 der Freilaufdiodeneinrichtung 10 (sh. Fig. 1), wobei die Linie 39 den zeitlichen Verlauf des die erste Diode 12 durchfließenden elektrischen Stromes I, die Linie 40 den zeitlichen Verlauf des die zweite Diode 14 durchfließenden elektrischen Stromes I und die Linie 42 die Summe der beiden zuletzt genannten elektrischen Ströme, d.h. den Gesamtstrom I der Freilaufdiodeneinrichtung 10 in Abhängigkeit von der Zeit, darstellt. Der Stromverlauf entspricht dem Stromverlauf gemäß Linie 35 in Fig. 4, jedoch in einem anderen Maßstab. In dem dargestellten Beispiel trägt die erste Diode 12 16 A und die zweite Diode 14 34 A, so daß der Gesamtstrom $I_{ges}$ der Freilaufdiodeneinrichtung 10 50 A beträgt.

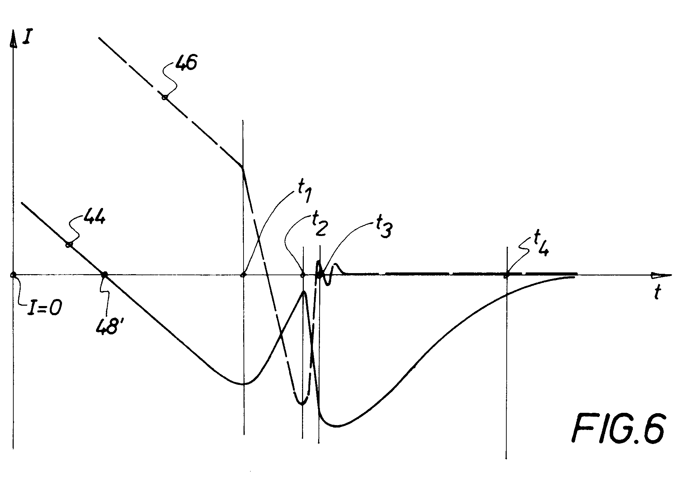

Fig. 6 verdeutlicht in einem größeren Zeitmaßstab genauer die Schaltvorgänge in den beiden Dioden 12 und 14 der Freilaufdiodeneinrichtung 10 zum Zeitpunkt der Kommutierung, wobei in dieser Figur zum besagten Zeitpunkt der elektrische Strom I in jeder der beiden Dioden verdeutlicht ist. Die Linie 44 zeigt die zeitliche Änderung des die erste Diode 12 durchfließenden elektrischen Stromes und die Linie 46 verdeutlicht die zeitliche Änderung des die zweite Diode 14 der Freilaufdiodeneinrichtung 10 durchfließenden elektrischen Stromes.

Zunächst wird der Strom in jeder der beiden Dioden 12 und 14 mit ca. 50 A/$\mu$s kommutiert. Die erste Diode 12 erreicht entsprechend der Kurve 44 in Fig. 6 zuerst den Nulldurchgang (bei 48) und zum Zeitpunkt $t_1$ einen Rückstromwendepunkt. Ab diesem Zeitpunkt $t_1$ wäre die erste Diode 12 bereit, elektrische Spannung aufzunehmen. Zu diesem Zeitpunkt $t_1$ ist jedoch die zweite Diode 14 noch von elektrischem Strom in Vorwärtsrichtung durchflossen, wie durch die Linie 46 in Fig. 6 ersichtlich ist.

Das bedeutet, daß zu diesem Zeitpunkt $t_1$ noch keine elektrische Spannung aufgebaut werden kann. Ab dem Zeitpunkt $t_1$ wird nun der Strom in der zweiten Diode 14 besonders steil kommutiert, bis sie zum Zeitpunkt $t_2$ ebenfalls elektrische Spannung aufnehmen kann. Zwischen den Zeitpunkten $t_1$ und $t_2$ liegt an den beiden Dioden 12 und 14 noch nicht die elektrische Spannung an, gegen welche kommutiert wird. In der zweiten Diode 14 wird zwischen den Zeitpunkten $t_1$ und $t_2$ der pn-Übergang von elektrischen Überschußladungsträgern ausgeräumt. In der ersten Diode 12 geht der Rückstrom um den Betrag zurück, der von der zweiten Diode 14 übernommen wird. Der Gesamtstrom aus den die erste und die zweite Diode 12, 14 durchfließenden Teilströmen ist während dieser Zeitspanne durch die äußere Schaltung aufgeprägt. Zum Zeitpunkt $t_2$ wird in der zweiten Diode 14 der pn-Übergang frei von elektrischen Ladungsträgern; daraufhin zeigt die zweite Diode 14 einen scharfen Rückstromabriß. Dieser Rückstromabriß bewirkt jedoch nur eine Verlagerung des elektrischen Stromes in die erste Diode 12, die nach wie vor genug Ladungsträger enthält. Zum Zeitpunkt $t_3$ ist die zweite Diode 14 bereits ausgeräumt. Es tritt keine durch einen Stromabriß erzeugte Überspannung auf, da der Gesamtstrom nicht abreißt. Die ansteigende Spannung bewirkt in der ersten Diode 12 ein Ausräumen der restlichen Ladungsträger. Dieser Verlauf ist bis zum Zeitpunkt $t_4$ durch ein weiches Recovery-Verhalten bestimmt.

Die nachfolgende Tabelle gibt in einem Beispiel eine Übersicht der wesentlichen Parameter der ersten und der zweiten Diode 12, 14 sowie der Parallelschaltung der beiden Dioden zur erfindungsgemäßen Freilaufdiodeneinrichtung. Aus der Tabelle ist ersichtlich, daß die Sperrverzögerungsladung $Q_{RR}$ um mehr als 50 % reduziert ist. Das wirkt sich direkt auf die Schaltverluste vorteilhaft aus. Die Schaltverluste betragen nur noch ca. 40 % der Schaltverluste der ersten Diode 12.

Erfindungsgemäß ist es also möglich, die Durchlaßverluste und die Schaltverluste zu entkoppeln und diese beiden Parameter voneinander getrennt zu optimieren. Desweiteren sind -wie bereits erwähnt- die Schaltverluste in vorteilhafter Weise wesentlich reduziert.

<u>Tabelle</u>

Parallelschaltung einer Protonen-bestrahlten Diode 12 (soft bei 125°C) und einer Gold-diffundierten Epitaxial-Diode 14 (snappig bei 125°C)

|  | Diode 12 allein | Diode 14 allein | Freilaufdioden-einrichtung 10 (beide Dioden parallelgesch.) |
|---|---|---|---|
| $I_{RR}$ (50 A, -100 A/µs, 250V, 125°C) | 18,4A | 4,9 A | 11,8 A |
| $Q_{RR}$ (50 A, -100 A/µs, 250V, 125°C) | 5,7 µC | 0,3 µC | 2,4 µC |
| $V_m$ (50 A, -100 A/µs, 250V, 125°C) | 404 V | 490 V | 396 V |
| $W_{off}$ | 1080µJ | < 80µJ | 394 µJ |
| $I_F$ bei Parallel-schaltung |  |  | 50 A Aufteilung: 1.Diode :16A 2.Diode :34A |

In der Tabelle bedeuten:

$I_{RR}$ = Rückstromspitze

$Q_{RR}$ = Sperrverzögerungsladung

$V_m$ = Bei der Kommutierung auftretende Spitzenspannung (Maß für die Softness)

$W_{off}$ = Schaltverluste

$I_F$ = Gesamtstrom

**Patentansprüche**

**1.** Freilaufdiodeneinrichtung für einen ein schaltbares Bauelement aufweisenden Kommutierungszweig, **dadurch gekennzeichnet, daß** die Freilaufdiodeneinrichtung (10) eine erste Diode (12) mit einem weichen Schaltverhalten und eine dazu parallelgeschaltete zweite Diode (14) mit einem harten Schaltverhalten aufweist.

2. Freilaufdiodeneinrichtung nach Anspruch 1., dadurch gekennzeichnet, daß die erste Diode (12) auf weiches Schaltverhalten optimiert ist und nur einen relativ geringen Anteil des Vorwärtsstromes trägt, und die zweite Diode (14) auf einen niedrigen Durchlaßspannungsabfall und schnelles Schalten optimiert ist und einen im Vergleich zum Anteil der ersten Diode (12) großen Anteil des Vorwärtsstromes trägt.

3. Einrichtung nach Anspruch 1,
   **dadurch gekennzeichnet**,
   daß die erste Diode (12) eine auf entsprechend weiches Schaltverhalten ausgerichtete breite $n^-$-Zone aufweist und die zweite Diode (14) eine pin-Diode mit schmaler i-Zone ist.

4. Einrichtung nach Anspruch 1,
   **dadurch gekennzeichnet**,
   daß die erste Diode (12) eine $p^+$-Zone von herabgesetztem Emitterwirkungsgrad aufweist, während die zweite Diode (14) eine $p^+$-Zone von hohem Emitterwirkungsgrad aufweist.

5. Einrichtung nach Anspruch 1,
   **dadurch gekennzeichnet**,
   daß die erste Diode (12) eine Protonen-bestrahlte Freilauf-Diode und die zweite Diode (14) eine Golddiffundierte Epitaxial-Diode ist.

6. Einrichtung nach einem der vorhergehenden Ansprüche,
   **dadurch gekennzeichnet**,
   daß das Verhältnis des Anteiles des Vorwärtsstromes der ersten Diode (12) zum Anteil des Vorwärtsstromes der zweiten Diode (14) kleiner als 1:2 bis maximal größenordnungsmäßig 1:2 beträgt.

7. Einrichtung nach Anspruch 1,
   **dadurch gekennzeichnet**,
   daß die Trägerlebensdauer in der zweiten Diode (14) so eingestellt ist, daß ihre Rückstromhöhe auch bei steiler Kommutierung kleiner ist als der Rückstrom in der ersten Diode (12).

FIG.1

FIG.2

FIG.3

FIG.4

EP 0 538 614 A2

FIG.5

FIG.6